**Europäisches Patentamt**

**European Patent Office**

**Office européen des brevets**

(19)

(11) Veröffentlichungsnummer: **0 199 030**

**A2**

# (12) EUROPÄISCHE PATENTANMELDUNG

(21) Anmeldenummer: **86102821.5**

(22) Anmeldetag: **04.03.86**

(51) Int. Cl.4: **H01L 21/90 , H01L 23/52**

(30) Priorität: **11.04.85 DE 3513024**

(43) Veröffentlichungstag der Anmeldung:
**29.10.86 Patentblatt 86/44**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Hieber, Konrad, Dr.**
**Laubensteinstrasse 7**
**D-8214 Bernau(DE)**
Erfinder: **Neppl, Franz, Dr.**
**St.-Quirin-Platz 6**
**D-8000 München 90(DE)**
Erfinder: **Schober, Konrad, Dipl.-Phys.**
**Annette-Kolb-Anger 13**
**D-8000 München 83(DE)**

(54) **Verfahren zum Herstellen einer Mehrlagenverdrahtung von integrierten Halbleiterschaltungen mit mindestens einer aus einer Aluminiumlegierung bestehenden Leitbahnebene mit Kontaktlochauffüllung.**

(57) Bei einem Verfahren zum Herstellen einer Mehrlagenverdrahtung von integrierten Halbleiterschaltungen mit mindestens einer aus einer Aluminiumlegierung bestehenden Leitbahnebene werden vor dem Abscheiden der aus der Aluminiumlegierung bestehenden Leitbahnebene (5) die Kontaktlöcher zu den diffundierten Bereichen im Substrat und die Kontaktlöcher (3) (via holes) zu den darunterliegenden Leitbahnebenen (1) mit reinem, durch Niederdruck-Gasphasenabscheidung (LPCVD) hergestelltem Aluminium (4) aufgefüllt, das Aluminium (4) bis auf Kontaktlochhöhe zurückgeätzt und dann ganzflächig die aus der Aluminiumlegierung bestehende Leitbahnebene (5) durch Kathodenzerstäubung (Sputtern) abgeschieden. Das Verfahren ermöglicht die Herstellung zuverlässiger, mit hohen Stromdichten belastbarer Kontakte. Wegen der im Kontaktloch (3) befindlichen Aluminiumfüllung (4) findet keine Schichtdickenabnahme im Kontaktlochbereich statt, so daß auch an diesen Stellen eine Strombelastung nicht kritisch ist. Das Verfahren wird verwendet bei VLSI-Schaltungen (4M DRAM).

## FIG 3

**Verfahren zum Herstellen einer Mehrlagenverdrahtung von integrierten Halbleiterschaltungen mit mindestens einer aus einer Aluminiumlegierung bestehenden Leitbahnebene mit Kontaktlochauffüllung.**

Die Erfindung betrifft ein Verfahren zum Herstellen einer Mehrlagenverdrahtung von integrierten Halbleiterschaltungen mit mindestens einer aus einer Aluminiumlegierung bestehenden Leitbahnebene, bei dem die Kontaktlöcher zu den diffundierten Bereichen im Halbleitersubstrat und/oder die Kontaktlöcher (via holes) zu einer weiteren Leitbahnebene der Schaltung vor dem Abscheiden der aus der Aluminiumlegierung bestehenden Leitbahnebene mit einem Metall aufgefüllt werden.

Bei der fortschreitenden Miniaturisierung von Halbleiterbauelementen treten bereits Strukturen im Bereich von 1 µm und darunter auf. Um die sehr kleinen aktiven Bereiche auf dem Halbleitersubstrat elektrisch ansteuern zu können, müssen diese mit metallischen Leitbahnen verbunden werden. Damit dieser Kontakt nur an definierten Stellen stattfindet, ist die Leitbahn durch eine Isolationsschicht, z.B. aus $SiO_2$ bestehend, vom Halbleitersubstrat getrennt. Die Verbindung zu den aktiven Bereichen des Halbleitersubstrats findet über Kontaktlöcher statt, die in die Isolationsschicht eingeätzt werden. Analoge Verhältnisse herrschen auch bei höchstintegrierten Bauelementen, wobei zwei und mehr Leitbahnebenen für die elektrische Versorgung der sehr dicht gepackten aktiven Bereiche notwendig sind. Auch in diesem Fall muß ein elektrischer Kontakt durch sehr kleine Löcher (via holes) zwischen den verschiedenen Leitbahnebenen hergestellt werden.

Da aufgrund von schaltungstechnischen Überlegungen (z.B. parasitäre Kapazitäten) die Isolationsschicht eine Mindestdicke von 0,7 -1,5 µm besitzen muß, treten bei den Kontaktlöchern bzw. via holes Tiefen/Durchmesser-Verhältnisse von $\geq 1$ auf. Bei diesen sehr kleinen und tiefen Kontaktlöchern nimmt die Schichtdicke der Leitbahnen an den Flanken des Kontaktloches sehr stark ab (55-80% Abnahme), wenn das Leitbahnmaterial, z. B. Aluminiumlegierungen: Aluminium-Silizium (1%), wie bisher üblich durch Kathodenzerstäubung (Sputtern) aufgebracht wird. Da die Leitbahnen mit extrem hohen Stromdichten belastet sind (z.B. 1 $\times$ $10^6 A/cm^3$) bewirkt eine jede Querschnittsverengung einen lokalen Temperaturanstieg, der an den Grenzflächen zwischen den verschiedenen Materialien im Kontakt einen unerwünschten Materialtransport (Diffusion, Reaktion) beschleunigt. Dies kann auch bis zum Durchbrennen einer Leitbahn führen.

Bereits für die Beschichtung von Kontaktlöchern mit einem Tiefen/Durchmesser-Verhältnis von $\leq 1$ müssen mehrere Maßnahmen getroffen werden, um an den vertikalen Flanken noch 25-60% der horizontalen Schichtdicke zu erreichen.

So ist aus einem Aufsatz von W. R. Bottoms, Solid State Technol. Aug. (1984) S. 155-159 bekannt, die Kontaktlochflanken durch ein trichterförmiges Profil zu verrunden.

In einem Aufsatz von I. F. Smith aus Solid State Technol., Jan. (1984) S. 135-138 wird das Problem durch Aufstäuben der Metallisierungsschicht mit Biasspannung gelöst.

Eine weitere Maßnahmen ist das Aufstäuben bei hohen Substrattemperaturen (W. H. Class; I. F. Smith, 32nd und 33rd Sputtering Schools Turnberry, Scotland, Juni 1983, Dallas Texas, Dez. 1983, ST III-1 bis III-15, III-29-33).

In jüngster Zeit werden auch CVD ( = Chemical Vapor Deposition)-Verfahren, die sich durch eine sehr gute Kantenbedeckung auszeichnen, zum Auffüllen von Kontakten eingesetzt. Dabei kann man zwei verschiedene Methoden unterscheiden:

a) Ganzflächige Abscheidung der Metallisierungsschicht auf der Isolationsschicht einschließlich der Kontaktlöcher, unter Verwendung von Wolfram, wie aus einem Aufsatz von D. L. Brors et al aus dem Solid State Technol. April (1984). S. 313-314 bekannt ist: Aufgrund der guten Kantenbedeckung des CVD-Verfahrens wächst die Schicht im Kontaktloch von allen Seiten etwa gleich schnell und füllt somit das Kontaktloch auf. Dieser Zustand ist bei einer Schichtdicke (gemessen auf horizontaler Struktur), die etwas mehr als der Hälfte des Kontaktlochdurchmessers entspricht, eingetreten. Ätzt man nun die Metallschicht wieder ganzflächig ab, so kann erreicht werden, daß das Metall von der Isolierschicht vollständig entfernt ist, während das Kontaktloch noch mit Metall gefüllt bleibt.

b) Selektive Abscheidung der Metallisierungsschicht in Kontaktlöcher unter Verwendung von Wolfram oder Tantalsilizid als Kontaktlochfüller, wie z.B. aus einem Aufsatz von E.K. Broadbent et al in J. Electr. Chem. Soc. Solid State Sci. and Technol. - (1984) S. 1427-1433 oder aus der europäischen Patentanmeldung 0 090 319 bekannt ist: Bei dieser Variante des CVD-Verfahrens wird der Beschichtungsprozeß derart eingestellt, daß die chemische Reaktion, die die Beschichtung bewirkt, durch eine verangehende Reaktion mit einem bestimmten Substratmaterial, z.B. mit Silizium, lokal ausgelöst werden kann. Es kann somit erreicht werden, daß das Kontaktloch zumindest teilweise mit "Metall" aufgefüllt wird.

Der Nachteil der erwähnten CVD-Verfahren ist, daß sie sich nur mit Einschränkungen in einen Fertigungsprozeß für integrierte Halbleiterbauelemente einfügen lassen.

Wolfram kann zwar bei Temperaturen zwischen 350 und 550°C bis zu 1 μm Schichtdicke selektiv auf Silizium bzw. Aluminium abgeschieden werden, jedoch treten bei Temperaturen über 500°C Reaktionen mit Silizium und/oder Aluminium auf, was zu einer Verschlechterung der elektrischen Eigenschaften des Kontaktes führt. Zusätzlich wird bei der selektiven Wolframabscheidung aufgrund der die Selektivität auslösenden Reaktion (2 WF$_6$ + 3 Si → 3 SiF$_4$ + 2 W) Silizium geätzt (SiF$_4$ besitzt einen hohen Dampfdruck), was zu Kurzschlüssen zwischen dem Dotierungsgebiet und dem Substrat führen kann. Da Wolfram mit dem anschliessend abgeschiedenen Aluminium ebenfalls reagieren kann, treten auch an diesen Grenzflächen Fehlstellen auf. Wird die ganzflächige Wolframabscheidung, z.B. für die Auffüllung von via holes zwischen zwei Aluminium-Leitbahnebenen benützt, so ist auch hier zu beachten, daß die Beschichtungstemperatur unter 500°C liegt, da andernfalls das Isolationsmaterial (mechanische Spannungen) und die Aluminiumlegierungschicht (Kristallisation) geschädigt werden. Ein weiterer Nachteil ist, daß in einer Fertigung Ätzprozesse für Aluminium und Wolfram beherrscht werden müssen. Außerdem besitzt Wolfram einen höheren spezifischen elektrischen Widerstand als Aluminium.

Die selektive Tantalsilizid-Abscheidung auf Silizium liefert zwar eine stabile Materialkombination - (bis 900°C) und damit stabile elektrische Werte, jedoch ist die Abscheidetemperatur von z.B. 650°C zu hoch, um das Verfahren zum Auffüllen von via holes verwenden zu können.

Im Hinblick auf eine Prozeßvereinfachung wäre es vorteilhaft, sowohl für die Kontaktlöcher zu Silizium als auch für die via holes zwischen den Aluminiumleitbahnen dasselbe Auffüllverfahren verwenden zu können. Als Material wäre z.B. Aluminium oder eine Aluminiumlegierung besonders vorteilhaft.

Wie aus einem Aufsatz von M.L. Green et al aus Thin Solid Films, 114 (1984) S. 367-377 zu entnehmen ist, können mit dem CVD-Verfahren nur reine Aluminium-Schichten bei ca. 270°C abgeschieden werden; der Einsatz eines Aluminium-CVD-Verfahrens in der Halbleitertechnologie ist deshalb nicht möglich. Reines Aluminum als Leitbahnmaterial besitzt eine geringe Elektromigrationsbeständigkeit, ferner löst es sehr leicht Silizium, was zu einer Zerstörung des Kontaktes führt. Näheres über den als Aluminium-spiking bekannten Effekt ist aus einem Bericht von I. M. Poate et al aus Thin Films Interdiffusion and Reactions, John Wiley and Sons, New Yoruk 1978, S. 15-20 zu entnehmen. Ein weiterer Nachteil dieses Verfahrens ist, daß bei Schichtdicken größer 0,5 μm die Rauhigkeit so groß wird, daß das Material fotolithografisch nicht mehr strukturiert werden kann. Gleichzeitig sinkt der effektive Leitbahnquerschnitt, was lokal sehr hohe Stromdichten zur Folge hat.

Die Erfindung dient zur Lösung der Aufgabe, diese Probleme zu beheben und ein Verfahren anzugeben, mit dessen Hilfe stabile niederohmige Kontakte sowohl zwischen der Leitbahnebene und dem Halbleitersubstrat als auch zwischen den verschiedenen Leitbahnebenen, auch bei VLSI-Schaltungen, herstellbar sind. Die Erfindung betrifft ein Verfahren der eingangs genannten Art, welches durch folgende Merkmale gekennzeichnet ist:

a) Als Metallfüllung wird Aluminium verwendet, welches durch Niederdruck-Gasphasenabscheidung (LPCVD) hergestellt ist,

b) die Aluminiumschicht wird in solch einer Schichtdicke auf die das Kontaktloch enthaltende Oberfläche aufgebracht, daß eine vollständig ebene Oberfläche entsteht,

c) die Aluminiumschicht wird soweit wieder ganzflächig abgetragen, bis die das Kontaktloch enthaltende Oberfläche freigelegt ist und nur das Kontaktloch mit Aluminium gefüllt bleibt und

d) darauf wird die aus der Aluminium-Silizium-Legierung bestehende Leitbahn durch Kathodenzerstäubung (Sputtern) in der gewünschten Schichtdicke abgeschieden und strukturiert.

Da der LP-CVD-Aluminium-Prozeß nicht zur Herstellung von Leitbahnen, sondern nur zum Auffüllen von Kontaktlöchern bzw. via holes verwendet wird und in konventionellen Sputterverfahren die für Leitbahnen geeignete, mit hohen Stromdichten belastbare Aluminiumlegierung, welche gemäß einem Ausführungsbeispiel nach der Lehre der Erfindung aus Aluminium-Silizium-Titan mit 1 % Silizium und 0,2 % Titan besteht, aufgebracht wird, kommt es zu keiner Abnahme der Schichtdicke im Kontaktlochbereich und damit auch nicht zu einem Absinken des effektiven Leitbahnquerschnitts.

Um in den Kontaktlöchern zu den aktiven Bereichen im Siliziumsubstrat ein Eindiffundieren des reinen Aluminiums zu verhindern, ist in einer Weiterbildung des Erfindungsgedankens eine dünne Diffusionsbarriere aus Tantal-Silizium mit 35 Mol% Tantal, wie bereits in der europäischen Patentanmeldung 0 132 720 beschrieben, vorgesehen. Das Tantalsilizid läßt sich sehr gut im LP-CVD-Verfahren abscheiden. Bei der Auffüllung der via holes ist keine Barrierenschicht notwendig.

Da das bereits bekannte LP-CVD-Aluminium-Verfahren nur zum Auffüllen von Kontaktlöchern oder via holes verwendet wird, spielt die Tatsache, daß nur reines Aluminium abgeschieden werden kann, keine Rolle, da das Kontaktlochvolumen wesentlich kleiner ist als das Leitbahnvolumen. Ein Konzentrationsausgleich zwischen einer Aluminium-Silizium-Titan-Legierung und dem reinen Aluminium führt zu keinen Fehlstellen. Da ferner das rauhe LP-CVD-Aluminium rückgeätzt wird, ist auch keine Fototechnik, bei der die Rauhigkeit stören würde, für diesen Prozeßschritt notwendig.

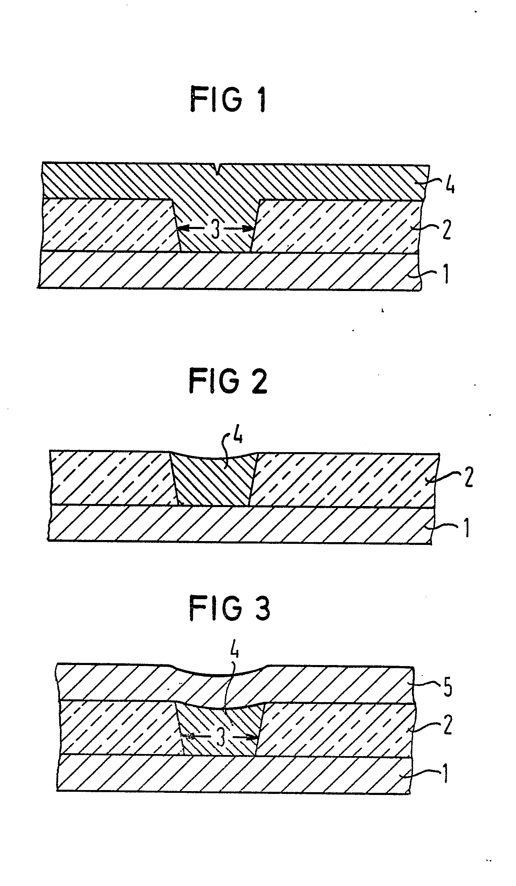

Im folgenden wird ein Ausführungsbeispiel der Erfindung anhand der Figuren 1 bis 3, welche die erfindungswesentlichen Verfahrensschritte beim Auffüllen von Kontaktlöchern (z.B. via holes) mit reinem Aluminium-CVD im Schnittbild darstellen noch näher beschrieben. In allen Figuren gelten für gleiche Teile gleiche Bezugszeichen.

Figur 1: Auf die mit dem Bezugszeichen 1 gekennzeichnete erste Aluminium-Leitbahnebene wird eine als Isolationsschicht wirkende $SiO_2$-Schicht 2 aufgebracht, in die das Kontaktloch 3 eingeätzt worden ist. Auf diese Anordnung wird ganzflächig nach dem LP-CVD-Verfahren so lange eine reine Aluminiumschicht 4 abgeschieden, bis die gesamte Oberfläche von Aluminium bedeckt ist. Dabei werden folgende Prozeßparameter eingestellt:

Triisobutyl-Aluminium (TIBA) wird bei zum Beispiel 45°C verdampft und in ein beheiztes Quarzrohr (zum Beispiel 260°C) eingeleitet. Im Quarzrohr herrscht ein Unterdruck von zum Beispiel 0,5 bis 1 mbar, der mit Vakuumpumpen erreicht wird. Bei 260°C zersetzt sich das TBA, wobei Al auf den im Quarzrohr befindlichen Siliziumscheiben kondensiert. Die Zersetzungsprodukte zum Beispiel Wasserstoff und Isobutylen werden abgepumpt. Die Beschichtungsrate beträgt ca. 30 nm/min.

Figur 2: Die reine Aluminiumschicht 4 wird dann ganzflächig wieder so weit abgetragen, bis die das Kontaktloch 3 enthaltende Oberfläche 2 wieder freigelegt ist und nur das Kontaktloch 3 mit Aluminium 4 gefüllt bleibt. Der Ätzprozeß geschieht in einem aus Bortrichlorid und Chlor bestehenden Plasma.

Figur 3: In einem konventionellen Sputterverfahren wird dann auf die Anordnung nach Figur 2 die für die Leitbahn geeignete, mit hohen Stromdichten belastbare Aluminium-Silizium-Titan-Legierung 5 als zweite Aluminium-Leit-bahnebene aufgebracht.

Die Fertigstellung der Schaltung erfolgt in bekannter Weise.

Es liegt im Rahmen der Erfindung, die Prozeßfolge für mehrere Leitbahnebenen beliebig oft zu wiederholen.

Mit der beschriebenen Prozeßfolge lassen sich sehr zuverlässige Kontakte sowohl zwischen der Aluminium-Leit-bahnebene und dem Halbleiter als auch zwischen den verschiedenen Aluminium-Leitbahnebenen herstellen. Die hohe Zuverlässigkeit kommt dadurch zustande, daß die gesputterten Aluminium-Legierungsschichten auf ein quasi ebenes Substrat aufgebracht werden. Da keine Schichtdickenabnahme im Kontaktloch bzw. via hole auftritt, ist die effektive Stromdichte an diesen Stellen geringer, so daß der Kontakt eine höhere Lebensdauer besitzt. Man hat aber auch die Möglichkeit die Stromdichten zu erhöhen, was z. B. bei einer weiteren Miniaturisierung der Fall ist.

Die Tatsache, daß die Aluminium-Legierungsschicht weniger Stufen aufweist hat zur Folge, daß gewisse Regeln beim Bauelementeentwurf (Design-Regeln) bezüglich der Anordnung von via holes und Kontaktlöchern entschärft werden, so daß man auch bei noch dichter gepackten Bauelementen eine hohe Zuverlässigkeit erreichen kann.

Die weiteren Vorteile liegen darin, daß Aluminium einen sehr geringen spezifischen elektrischen Widerstand besitzt und nur ein Ätzprozeß für Aluminium in der Fertigung sowohl für die Kontaktlochauffüllung als auch für die Strukturierung der Leitbahnebenen benötigt wird.

**Ansprüche**

1. Verfahren zum Herstellen einer Mehrlagenverdrahtung von integrierten Halbleiterschaltungen mit mindestens einer aus einer Aluminiumlegierung bestehenden Leitbahnebene, bei dem die Kontaktlöcher zu den diffundierten Bereichen im Halbleitersubstrat und/oder die Kontaktlöcher (via holes) zu einer weiteren Leitbahnebene der Schaltung vor dem Abscheiden der aus der Aluminiumlegierung bestehenden Leitbahnebene mit einem Metall aufgefüllt werden, **dadurch gekennzeichnet, daß**

a) als Metallfüllung (4) Aluminium verwendet wird, welches durch Niederdruck-Gasphasenabscheidung (LP-CVD) hergestellt ist,

b) die Aluminiumschicht (4) in solch einer Schichtdicke auf die das Kontaktloch (3) enthaltende Oberfläche (1, 2) aufgebracht wird, daß eine vollständig ebene Oberfläche entsteht,

c) die Aluminiumschicht (4) so weit wieder ganzflächig abgetragen wird, bis die das Kontaktloch (3) enthaltende Oberfläche (2) freigelegt ist und nur das Kontaktloch (3) mit Aluminium (4) gefüllt bleibt, und

d) darauf die aus der Aluminium-Silizium-Legierung bestehende Leitbahn (5) durch Kathodenzerstäubung (Sputtern) in der gewünschten Schichtdicke abgeschieden und strukturiert wird.

2. Verfahren nach Anspruch 1, **dadurch gekennzeichnet, daß** die Prozeßfolge für mehrere Leitbahnebenen beliebig oft wiederholt wird.

3. Verfahren nach Anspruch 1 und/oder 2, **dadurch gekennzeichnet, daß** eine Aluminiumlegierung für die Leitbahnebene (5) mit einem Siliziumgehalt von 1 % und einem Titangehalt von 0,2 % verwendet wird.

4. Verfahren nach mindestens einem der Ansprüche 1 bis 3, **dadurch gekennzeichnet, daß** vor der Füllung von Kontaktlöchern zu diffundierten Gebieten im Siliziumsubstrat eine aus Tantal-Silizium bestehende Legierung mit 35 Mol% Tantal als Diffusionsbarriere abgeschieden wird.

5. Verfahren nach Anspruch 4, **dadurch gekennzeichnet, daß** die Barrierenschicht auf eine Schichtdicke im Bereich von 50-150 nm eingestellt wird.

6. Verfahren nach mindestens einem der Ansprüche 1 bis 5, **dadurch gekennzeichnet, daß** der ganzflächige Abtrag der Aluminiumschicht (4) durch Trockenätzen in einem aus Bortrichlorid und Chlor bestehenden Plasma erfolgt.

# FIG 1

# FIG 2

# FIG 3